# EUROPEAN PATENT SPECIFICATION

(11) **EP 1 484 839 B1**
(45) Date of publication and mention of the grant of the patent: **23.07.2008**
(21) Application number: 03012553.8
(22) Date of filing: 02.06.2003
(51) Int. Cl.: H03F 1/02, H03F 1/30

(54) **System and method for controlling power amplification in mobile terminals**
System und Verfahren zur Regelung der Leistungsverstärkung in Mobilfunkendgeräten
Système et procédé de commande d'amplification de puissance dans des terminaux mobiles

(43) Date of publication of application: 08.12.2004
(73) Proprietor: Sony Ericsson Mobile Communications AB, 221 88 Lund (SE)
(72) Inventor: Radin-Macukat, Marjan, Sony Ericsson Mobile, 85609 Aschheim-Dornach (DE)
(74) Representative: Körber, Martin Hans

(56) References cited:
- WO-A-92/11702
- WO-A-02/097971
- US-A- 5 216 379
- US-A- 5 239 693
- US-A- 5 748 038

## Description

The invention relates to a system for controlling power amplification in mobile terminals according to claim 1 and to a method for controlling power amplification in mobile terminals according to claim 6.

Conventional mobile terminals for wireless communication in high frequency systems, e.g. the GSM or UMTS systems, usually comprise a closed loop power control circuit for controlling the output power of a high-frequency transmit power amplifier. The power amplifier circuits in present-day mobile terminals provide a power control voltage which can be applied to the power amplifier for manipulating or controlling the RF output power of the power amplification circuit. When a transmission is started the power control voltage is raised to start the power amplification. The initial charging of the power control voltage causes different problems, e.g. switching spectrum or time template.

A method for avoiding problems like a very broad frequency spectrum during initial transmission is revealed in document US 5,276,917. Hereby, the different stages of the power amplifier are sequentially switched on by providing a bias voltage to the different stages and by using separate power control signals for the different stages. Afterwards, the power amplification and transmission of high frequency signals is started.

The disadvantage of this system is the high technical effort, as different control voltages have to be generated, started and provided to the different stages of the power amplifier.

Other systems of the prior art are given by documents US 5,748,038 and WO 92/11702.

It is therefore the object of the present invention to provide a system and method for controlling the power amplification in mobile terminals , which solve the problems caused by the initial charging of the power control voltage and are of a simple construction and technical implementation and therefore provide an efficient power control of the power amplifier.

This object is achieved by a system as defined in claim 1 and a method as defined in claim 6. Further embodiments of the invention are set out in the dependent claims.

By using only one control signal which is common for all stages of the power amplifier and which is generated on the basis of the ramp signal as well as the bias ramp signal, a simplification in the construction and technical implementation is achieved.

Advantageously a subtracting unit generates a difference signal (V_{D}) by subtracting the sensing signal (V_{S}) of the detection means from the reference signal (V_{R}) of the ramp generator.

Further, advantageously an integrator integrates the difference signal (V_{D}) of the subtracting unit and outputs an integration signal (V_{I}).

Preferably a summing unit generates the control signal (V_{APC}) by summing up the integration signal (V_{I}) of the integrator and the additional signal (V_{BR}) of the bias ramp generator.

A processor may control the starting of the ramp generator and the bias ramp generator.

Advantageously the processor starts the ramp generator when the control signal (V_{APC}) is raised to the predefined level by the bias signal (V_{BR}) generated by the bias ramp generator.

Embodiments of the invention will now be described, by way of example only, with reference to the accompanying drawings, in which:
Fig. 1 is a block diagram showing schematically the elements of the system,
Fig. 2 is a graph showing two separated signals,
Fig. 3 is a graph showing the combined signals of the graph of Fig. 2 and
Fig. 4 is a block diagram showing a possible technical implementation of the present invention.

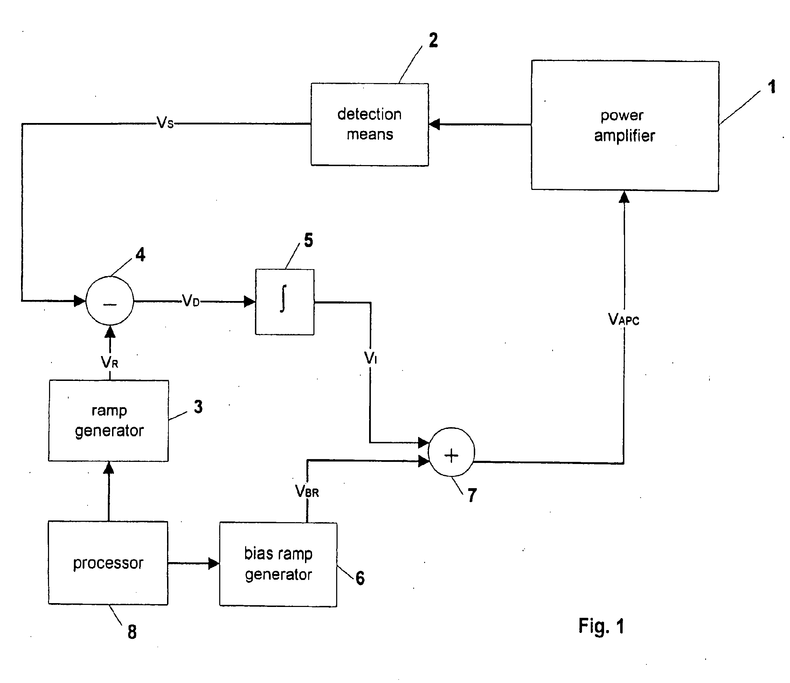

Figure 1 shows a schematic block diagram of the inventive system for controlling the power amplification in a mobile terminal for a wireless communication system, e.g. the GSM or UMTS system. The system comprises a power amplifier 1 for receiving an input signal, e.g. from a high frequency modulator controlled by a baseband processor, amplifying it and outputting the resulting high frequency signal to a transmission means or antenna (not shown) to be transmitted over the wireless communication system. Hereby, the power amplifier 1 may consist of several amplification stages linked together. The gain of the power amplifier 1 is controlled by the control signal V_{APC}. If the control signal V_{APC} is raised, also the amplification is augmented and conversely, if the control signal V_{APC} is lowered, also the gain of the power amplifier 1 declines. The control signal V_{APC} derives from a closed loop, in which the actual output power of the power amplifier 1 is measured, compared with a wanted output power and the V_{APC} is changed according to the difference between the actual and the wanted output power of the power amplifier 1.

For this purpose a detection means 2 measures the actual output power or the actual gain of the power amplifier I and provides a sensing signal Vs indicative of the actual output power. A ramp generator 3 generates a reference signal V_{R} indicative of the wanted output power of the power amplifier 1.

Both signals, the sensing signal Vs from the detection means 2 and the reference signal V_{R} from the ramp generator 3, are submitted to a subtracting unit 4. The subtracting unit 4 generates the difference between the sensing signal V_{S} from the detection means 2 and the reference signal V_{R} from the ramp generator by subtracting the sensing signal V_{S} from the reference signal V_{R}. The difference signal V_{D} is then output by the subtracting unit 4 and submitted to an integrator 5, where it is integrated and output as an integration signal V_{I}. The integration signal V_{I} therefore raises, if the reference signal V_{R} is higher than the sensing signal V_{S}, it decreases if the reference signal V_{R} is lower than the sensing signal Vs and it remains constant if the reference signal V_{R} and the sensing signal V_{S} match with each other.

A bias ramp generator 6 generates an additional signal V_{BR}, which is added to the integration signal V_{I} by a summing unit 7. The integration signal V_{I} generated by the integrator 5 and the additional signal V_{BR} generated by the bias ramp generator 6 are therefore submitted to the summing unit 7, summed up and output as the control signal V_{APC}, which is submitted to the power amplifier 1 in order to lower or raise the output power.

A processor 8 controls the ramp generator 3 and the bias ramp generator 6 and starts or stops the generation of the reference signal V_{R} by the ramp generator 3 and the generation of the additional signal V_{BR} by the bias ramp generator 6.

It is to be noted, that only components necessary for the understanding of the present invention are shown in Fig. 1. A representation of other components like for instance a power supply, a transmission control, an antenna or the like which are necessary for the operation of the power control circuit but show no reference to the principle underlying the present invention are omitted for the sake of clarity.

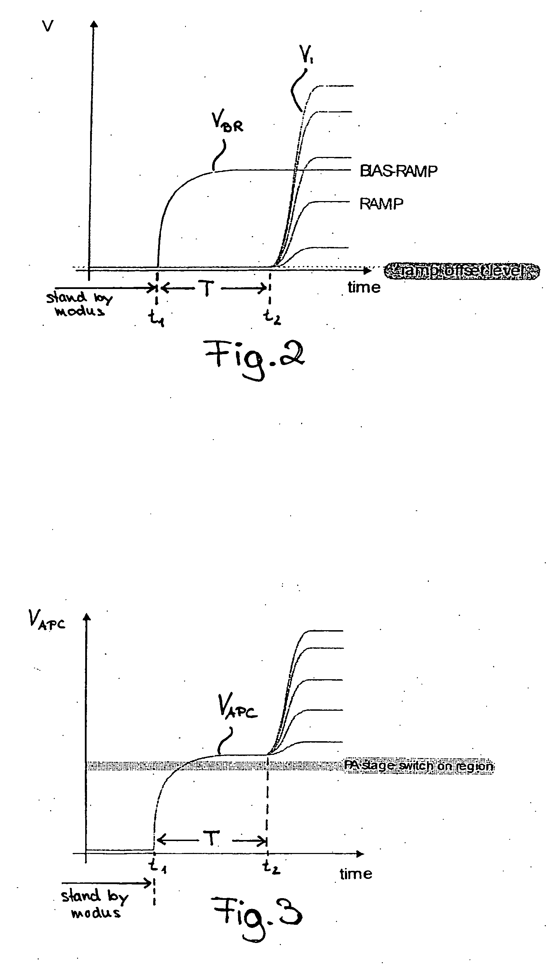

The process of starting a transmission and accordingly controlling the power amplifier 1 will now be explained with reference to the graphs shown in Fig. 2 and Fig. 3. Hereby, all the signals are measured and submitted as voltages.

Even when no transmission is performed, the high frequency voltage controlled oscillator (not shown) is active, and the power amplifier 1 therefore has some power on the input for the signal to be amplified. As this power is very high compared with the allowed power before the transmission start, the power amplifier 1 or at least one ore more of the stages of the power amplifier 1 are switched off, which may be done by a control signal V_{APC} close to 0V. During the time, when the control signal V_{APC} is close to 0V, the system is in a stand by modus and the power amplifier 1 before the start of the transmission works as an attenuator, that is the gain is negative, e.g. -39 dB.
In order to supply a control signal V_{APC} close to 0V to the power amplifier 1, the processor 8 controls the ramp generator 3 and the bias ramp generator 6 to be not active yet during the stand by modus.
In order to stop the stand by modus and to start the transmission, at a time ti shown in Fig. 2 the processor 8 starts the bias ramp generator 6 and an additional signal V_{BR} is generated. At a time t₂, which is later than t₁, also shown in Fig. 2, the processor 8 starts the ramp generator 3 and a reference signal V_{R} is generated. This reference signal V_{R} together with the sensing signal V_{S} generated by the detection means 2 is submitted to the subtracting unit 4. The difference signal V_{D} from the subtracting unit 4 is then integrated in the integrator 5 and output as integration signal V_{I}. The additional signal V_{BR} and the integration signal V_{I} are shown separately in Fig. 2.

With respect to the components according to Fig. 1 the control signal V_{APC} as shown in Fig. 3 is generated as follows: During the stand by modus the ramp generator 3 and the bias ramp generator 6 are not active. Further, due to an offset level of the detection means 2 close to 0V, which means, that a negative gain during power amplifier 1 working as attenuator is not detected, at the beginning the sensing signal V_{S}, the reference signal V_{R} and the additional signal V_{BR} are close to 0V, which results in a control signal V_{APC} close to 0V. At the time t₁ the bias ramp generator 6 is started by the processor 8 and the additional signal V_{BR} is generated and submitted to the summing unit 7. The control signal V_{APC} is therefore equal to the additional signal V_{BR} and independent of the output power of the power amplifier 1, as the ramp generator 3 is not active yet and the output V_{I} of the integrator 5 is 0V. After a predetermined time T=t₂ - t₁ the processor 8 starts the ramp generator 3 and the control signal V_{APC} is the sum of the additional signal V_{BR} and the integration signal V_{I} generated by the integrator 5.

When the ramp process starts, the power amplifier 1 works as attenuator, which means that the gain is lower than or equal to 0 dB. If a certain voltage range of the control signal V_{APC} is reached, e.g. PA switch on region in Fig. 3, the power amplifier 1 starts working as an amplifier, which means, that the gain is higher than 0 dB.
This way, the power amplifier 1 is forced to pass the switch on region, that is the shape of the control signal V_{APC}, is responsible for several problems. For example, if the control signal V_{APC} has a too steep slope in this region, its causing noise in the power amplifier 1, measured as high switching spectrum. On the other hand, if the control signal V_{APC} has a too flat slope in this region, then the lock time of the APC loop, that is the time, which is needed from the start of the ramp process until the power amplifier 1 works as an amplifier, is increased.

The time t₁ indicates the moment, when the stand by modus ends and the processor 8 starts the bias ramp generator 6. The time t₂ indicates the moment, when the processor 8 starts the ramp generator 3 and the reference signal V_{R} is added to the additional signal V_{BR}. As the processor 8 starts the ramp generator 3 only after the additional signal V_{BR} has passed the PA switch on region, the time t₂ and therefore also the difference T between t₁ and t₂ are predefined and depend on the shape of the additional signal V_{BR}. If for example, the shape is steep, then the time t₂ decreases, and if the shape is flat, then t₂ increases. The level and shape of the additional signal V_{BR} is calibrated during production process and the processor 8 starts the ramp generator 3 at the predefined time t₂ depending on the predefined shape of the additional signal V_{BR}.

By providing an additional signal V_{BR} with a specific shape and adding the reference signal V_{R} later after the passing of the sensitive switch on region, the lock time can be optimized and a good switching spectrum behavior can be achieved.
One additional signal V_{BR} therefore covers all power levels and one shape of the reference signal V_{R} is sufficient for all power levels, which results in a fast development and less processor power needed. Further, power calibration accuracy does not have influence on time template and switching spectrum performance, which improves the yield in the production process.

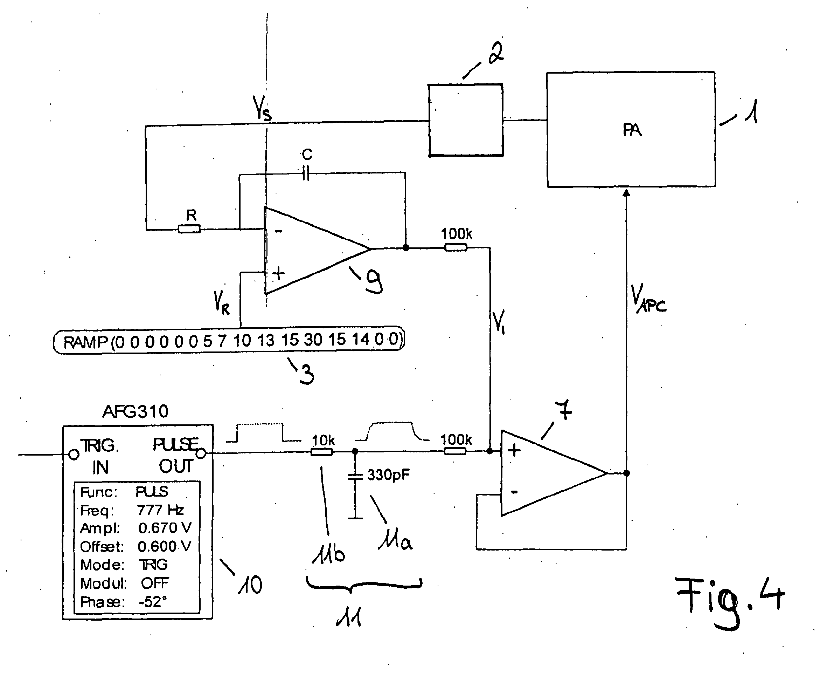

An example for a possible technical implementation will now be described with reference to Fig. 4. Hereby, the summing unit 7 is realized by using a first op-amp working as a summing unit. The subtracting unit 4 and the integrator 5 are realized by only one means, a second op-amp 9, which integrates the difference between the incoming signals V_{S} and V_{R}. The ramp generator 3 generates one reference signal V_{R} with one ramp shape and different power levels.
The ideal shape for the additional signal V_{BR} is cos² for minimum switching spectrum. This can for example be realized by using a DA converter and coefficients for shaping or, since the RF power is very low during the increase of the additional signal V_{BR}, a passive low pass filter. In Fig. 4 for generating the additional signal V_{BR} a bias ramp source function generator was used in PULS mode and is shaped by a RC low-pass filter 11 consisting of a capacitor 11a and resistor 11b.

## Claims

1. System for controlling power amplification in mobile terminals comprising
a power amplifier (1) for amplifying an input power signal into an output power signal for transmission,
a detection means (2) for sensing the actual transmission power of the power amplifier (1) and for providing a sensing signal (V_{S}) indicative of said actual transmission power, a ramp generator (3) for generating a reference signal (V_{R}) indicative of a wanted transmission power and
a bias ramp generator (6) for generating a bias signal (V_{BR}) for raising a control signal (V_{APC}) to a predefined level,
**characterized in,**
**that** the amplification of the power amplifier (1) is changed according to the control signal (V_{APC}), which is generated on the basis of the signals (V_{S}, V_{R}, V_{BR}) received from the detection means (2), the ramp generator (3) and the bias ramp generator (6), and
**that** the ramp generator (3) is adapted to generate said reference signal (V_{R}) only when the control signal (V_{APC}) is raised to the predefined level by the bias signal (V_{BR}) generated by the bias ramp generator (6).

2. System according to claim 1,
**characterized in,**
**that** a subtracting unit (4) generates a difference signal (V_{D}) by subtracting the sensing signal (V_{S}) of the detection means (2) from the reference signal (V_{R}) of the ramp generator (3).

3. System according to claim 1 or 2,
**characterized in,**
**that** an integrator (5) integrates the difference signal (V_{D}) of the subtracting unit (4) and outputs an integration signal (V_{I}).

4. System according to one of the claims 1 to 3,
**characterized in,**
**that** a summing unit (7) generates the control signal (V_{APC}) by summing up the integration signal (V_{I}) of the integrator (5) and the additional signal (V_{BR}) of the bias ramp generator (6).

5. System according to on of the claims 1 to 4,
**characterized in,**
**that** a processor (8) controls the starting of the ramp generator (3) and the bias ramp generator (6).

6. Method for controlling power amplification in mobile terminals comprising the steps of
amplifying an input power signal into an output power signal for transmission, sensing the actual transmission power and providing a sensing signal (V_{S}) indicative of said actual transmission power,
generating a reference signal (V_{R}) indicative for a wanted transmission power and generating a bias signal (V_{BR}) for raising a control signal (V_{APC}) to a predefined level,
**characterized in**
changing the amplification according to the control signal (V_{APC}), which is generated on the basis of said sensing signal (V_{S}), reference signal (V_{R}), bias signal (V_{BR}), whereby
said reference signal (V_{R}) is generated only when the control signal (V_{APC}) is raised to the predefined level by the bias signal (V_{BR}).

7. Method according to claim 6,
**characterized in**
generating a difference signal (V_{D}) by subtracting the sensing signal (V_{S}) from the reference signal (V_{R}).

8. Method according to claim 6 or 7,
**characterized in** integrating the difference signal (V_{D}) and outputting an integration signal (V_{I}).

9. Method according to one of the claims 6 to 8,
**characterized in**
generating the control signal (V_{APC}) by summing up the integration signal (V_{I}) and the additional signal (V_{BR}).

10. Method according to on of the claims 6 to 9,
**characterized in**
controlling the starting of the reference signal (V_{R}) and the additional signal (V_{BR}).

## Patentansprüche

1. System zur Steuerung der Leistungsverstärkung in mobilen Endgeräten,
welches aufweist:
einen Leistungsverstärker (1) zur Verstärkung eines Eingangsleistungssignals zu einem Ausgangsleistungssignal für die Übertragung,
ein Erfassungsmittel (2) zur Erfassung der tatsächlichen Übertragungsleistung des Leistungsverstärkers (1) und zur Bereitstellung eines Erfassungssignals (V_{S}), welches die tatsächliche Übertragungsleistung angibt,
einen Sägezahngenerator (3) zur Erzeugung eines Bezugssignals (V_{R}), welches eine gewünschte Übertragungsleistung angibt, und
einen Vorspannungs-Sägezahngenerator (6) zur Erzeugung eines Vorspannungssignals (V_{BR}) zur Verstärkung eines Steuersignals (V_{APC}) auf einen vorgegebenen Pegel,
**dadurch gekennzeichnet,**
**dass** sich die Verstärkung des Leistungsverstärkers (1) gemäß dem Steuersignal (V_{APC}) ändert, welches basierend auf den von Erfassungsmittel (2), Sägezahngenerator (3), Vorspannungs-Sägezahngenerator (6) empfangenen Signalen (V_{S}, V_{R}, V_{BR}) erzeugt wird, und
**dass** der Sägezahngenerator (3) das Bezugssignal (V_{R}) nur erzeugen kann, wenn das Steuersignal (V_{APC}) durch das vom Vorspannungs-Sägezahngenerator (6) erzeugte Vorspannungssignal (V_{BR}) auf den vorgegebenen Pegel verstärkt wird.

2. System nach Anspruch 1
**dadurch gekennzeichnet,**
**dass** ein Subtrahierer (4) ein Differenzsignal (V_{D}) durch Subtraktion des Erfassungssignals (V_{S}) des Erfassungsmittels (2) vom Bezugssignal (V_{R}) des Sägezahngenerators (3) erzeugt.

3. System nach Anspruch 1 oder 2
**dadurch gekennzeichnet,**
**dass** ein Integrator (5) das Differenzsignal (V_{D}) des Subtrahierers (4) integriert und ein Integriersignal (V_{I}) ausgibt.

4. System nach einem der Ansprüche 1 bis 3,
**dadurch gekennzeichnet,**
**dass** ein Summierer (7) das Steuersignal (V_{APC}) durch Aufsummierung des Integriersignals (V_{I}) des Integrierglieds (5) und des zusätzlichen Signals (V_{BR}) des Vorspannungs-Sägezahngenerators (6) erzeugt.

5. System nach einem der Ansprüche 1 bis 4,
**dadurch gekennzeichnet,**
**dass** ein Prozessor (8) die Aktivierung des Sägezahngenerators (3) und des Vorspannungs-Sägezahngenerators (6) steuert.

6. Verfahren zur Steuerung der Leistungsverstärkung in mobilen Endgeräten, welches die folgenden Schritte aufweist:
Verstärkung eines Eingangsleistungssignals zu einem Ausgangsleistungssignal für die Übertragung,
Erfassung der tatsächlichen Übertragungsleistung des Leistungsverstärkers (1) und
Bereitstellung eines Erfassungssignals (V_{S}), welches die tatsächliche Übertragungsleistung angibt,
Erzeugung eines Bezugssignals (V_{R}), welches eine gewünschte Übertragungsleistung angibt, und
Erzeugung eines Vorspannungssignals (V_{BR}) zur Verstärkung eines Steuersignals (V_{APC}) auf einen vorgegebenen Pegel,
**dadurch gekennzeichnet,**
**dass** sich die Verstärkung gemäß dem Steuersignal (V_{APC}) ändert, welches basierend auf Erfassungssignal (V_{S}), Bezugssignal (V_{R}) und Vorspannungssignal (V_{BR}) erzeugt wird, wobei
das Bezugssignal (V_{R}) nur erzeugt wird, wenn das Steuersignal (V_{APC}) durch das Vorspannungssignal (V_{BR}) auf den vorgegebenen Pegel verstärkt wird.

7. System nach Anspruch 6
**dadurch gekennzeichnet,**
**dass** ein Differenzsignal (V_{D}) durch Subtraktion des Erfassungssignals (V_{S}) vom Bezugssignal (V_{R}) erzeugt wird.

8. System nach Anspruch 6 oder 7
**dadurch gekennzeichnet,**
**dass** das Differenzsignal (V_{D}) integriert und ein Integriersignal (V_{I}) ausgegeben wird.

9. System nach einem der Ansprüche 6 bis 8,
**dadurch gekennzeichnet,**
**dass** das Steuersignal (V_{APC}) durch Aufsummierung von Integriersignal (V_{I}) und zusätzlichem Signal (V_{BR}) erzeugt wird.

10. System nach einem der Ansprüche 6 bis 9,
**dadurch gekennzeichnet,**
**dass** die Aktivierung des Bezugssignals (V_{R}) und des zusätzlichen Signals (V_{BR}) gesteuert wird.

## Revendications

1. Système pour commander une amplification de puissance dans des terminaux mobiles,
comportant
un amplificateur de puissance (1) destiné à amplifier un signal de puissance d'entrée en un signal de puissance de sortie pour une émission,
un moyen de détection (2) destiné à capter la puissance d'émission réelle de l'amplificateur de puissance (1) et à produire un signal de détection (V_{S}) représentatif de ladite puissance d'émission réelle,
un générateur (3) de rampe destiné à générer un signal de référence (V_{R}) représentatif d'une puissance d'émission voulue et
un générateur (6) de rampe de polarisation destiné à générer un signal de polarisation (V_{BR}) pour élever un signal de commande (V_{APC}) à un niveau prédéfini,
**caractérisé en ce que**
l'amplification de l'amplificateur de puissance (1) est modifiée en fonction du signal de commande (V_{APC}), lequel est généré sur la base des signaux (V_{S}, V_{R}, V_{BR}) reçus du moyen de détection (2), du générateur de rampe (3) et du générateur de rampe de polarisation (6), et
le générateur de rampe (3) est conçu pour générer ledit signal de référence (V_{R}) uniquement lorsque le signal de commande (V_{APC}) est élevé au niveau prédéfini par le signal de polarisation (V_{BR}) généré par le générateur (6) de rampe de polarisation.

2. Système selon la revendication 1,
**caractérisé en ce que**
une unité de soustraction (4) génère un signal de différence (V_{D}) en soustrayant le signal de détection (V_{S}) du moyen de détection (2) du signal de référence (V_{R}) du générateur de rampe (3).

3. Système selon la revendication 1 ou 2,
**caractérisé en ce que**
un intégrateur (5) intègre le signal de différence (V_{D}) de l'unité de soustraction (4) et délivre en sortie un signal d'intégration (V_{I}).

4. Système selon l'une des revendications 1 à 3,
**caractérisé en ce que**
une unité de sommation (7) génère le signal de commande (V_{APC}) en effectuant une sommation du signal d'intégration (V_{I}) de l'intégrateur (5) et du signal additionnel (V_{BR}) du générateur (6) de rampe de polarisation.

5. Système selon l'une des revendications 1 à 4,
**caractérisé en ce que**
un processeur (8) commande le démarrage du générateur de rampe (3) et du générateur de rampe de polarisation (6).

6. Procédé pour commander une amplification de puissance dans des terminaux mobiles, comprenant les étapes qui consistent :
à amplifier un signal de puissance d'entrée en un signal de puissance de sortie pour une émission,
à détecter la puissance d'émission réelle et à produire un signal de détection (V_{S}) représentatif de ladite puissance d'émission réelle,
à générer un signal de référence (V_{R}) représentatif d'une puissance d'émission voulue et
à générer un signal de polarisation (V_{BR}) pour élever un signal de commande (V_{APC}) à un niveau prédéfini,
**caractérisé en ce que**
l'amplification est modifiée en fonction du signal de commande (V_{APC}), lequel est généré sur la base dudit signal de détection (V_{S}), dudit signal de référence (V_{R}) et dudit signal de polarisation (V_{BR}), grâce à quoi
ledit signal de référence (V_{R}) est généré uniquement lorsque le signal de commande (V_{APC}) est élevé au niveau prédéfini par le signal de polarisation (V_{BR}).

7. Procédé selon la revendication 6,
**caractérisé par**
la génération d'un signal de différence (V_{D}) en soustrayant le signal de détection (V_{S}) du signal de référence (V_{R}).

8. Procédé selon la revendication 6 ou 7,
**caractérisé par**
l'intégration du signal de différence (V_{D}) et la sortie d'un signal d'intégration (V_{I}).

9. Procédé selon l'une des revendications 6 à 8,
**caractérisé par**
la génération du signal de commande (V_{APC}) en effectuant la sommation du signal d'intégration (V_{I}) et du signal additionnel (V_{BR}).

10. Procédé selon l'une des revendications 6 à 9,
**caractérisé par**
la commande du démarrage du signal de référence (V_{R}) et du signal additionnel (V_{BR}).
